Europäisches Patentamt

European Patent Office

Office européen des brevets

(19)

(11) Veröffentlichungsnummer: **0 177 747**
**B1**

(12) # EUROPÄISCHE PATENTSCHRIFT

(45) Veröffentlichungstag der Patentschrift:
**29.11.89**

(51) Int. Cl.⁴: **H 03 B 21/02**

(21) Anmeldenummer: **85111058.5**

(22) Anmeldetag: **02.09.85**

(54) **Kammspektrum-Oszillator.**

(30) Priorität: **03.09.84 DE 3432350**

(43) Veröffentlichungstag der Anmeldung:
**16.04.86 Patentblatt 86/16**

(45) Bekanntmachung des Hinweises auf die Patenterteilung:
**29.11.89 Patentblatt 89/48**

(84) Benannte Vertragsstaaten:
**DE FR GB IT**

(56) Entgegenhaltungen:
**DE-A- 1 591 481**
**DE-A- 3 322 325**
**US-A- 3 644 827**
**US-A- 4 105 949**
**US-A- 4 516 085**

**IEEE TRANSACTIONS ON MICROWAVE THEORY AND TECHNIQUES, Band MTT-30, Nr. 5, Mai 1982, Seiten 686-693, New York, US; A.J. BUDREAU et al.: "A review of SAW-based direct frequency synthesizers"**
**MICROWAVE JOURNAL, Band 25, Nr. 2, Februar 1982, Seiten 71-73, 76-80, Dedham, US; A.J. BUDREAU et al.: "Fast frequency hopping achieved with SAW synthesizers"**

(73) Patentinhaber: **C. Plath GmbH Nautisch-Elektronische Technik, Gotenstrasse 18, D-2000 Hamburg 1 (DE)**

(72) Erfinder: **Harders, Bodo, Dipl.-Ing., Am Sande 13, D-2059 Müssen (DE)**

(74) Vertreter: **Vossius & Partner, Siebertstrasse 4 P.O. Box 86 07 67, D-8000 München 86 (DE)**

**Beschreibung**

Die Erfindung betrifft einen Hochfrequenz-Oszillator, dessen Spektrum aus einer bestimmten, frei wählbaren Anzahl und Folge von Einzelfrequenzen besteht. Ein derartiger Kammfrequenz-Oszillator kann in verschiedenen hochfrequenztechnischen Anlagen verwendet werden, insbesondere in einem Empfänger zum Empfang und/oder zur Peilung von Sendern, die nach dem Frequenzsprungverfahren arbeiten. Weitere Verwendungsmöglichkeiten ergeben sich beispielsweise bei automatischen Frequenzzählern oder in einem Harmonic-Generator beim Netzwerkanalysator.

Um eine bessere Ausnützung vorhandener Kanäle und eine höhere Störsicherheit und Abhörsicherheit zu erzielen, werden in zunehmendem Masse Nachrichtensender eingesetzt, die nach dem Frequenzsprungverfahren arbeiten. Um derartige Sender empfangen zu können, ist auf der Empfängerseite eine Synchronisationseinrichtung erforderlich, die dafür sorgt, dass die augenblicklich gesendete Frequenz des Senders vom Empfänger erfasst werden kann. Mit üblichen Fremdempfängern, beispielsweise Peilempfängern, die der Nachrichtenverbindung zwischen dem nach dem Frequenzsprungverfahren arbeitenden Sender und autorisierten Empfängern nicht angehören, ist der Empfang derartiger frequenzagiler Sender nicht möglich, da den Fremdempfängern die Synchronisation der meist pseudo-zufälligen Folge der Sprungfrequenzen fehlt.

Um den Empfang von nach dem Frequenzsprungverfahren arbeitenden Sendern dennoch zu ermöglichen, wurden sehr aufwendige Empfänger konzipiert, die meist eine Frequenznachsteuerung anstreben. Derartige Empfänger sind aber schwer zu realisieren und zeigen keine befriedigenden Ergebnisse. Ein weiteres Problem tritt dann auf, wenn im vorgegebenen Gesamtfrequenzbereich des Frequenzrasters eines derartigen Senders ein mit fester Frequenz arbeitender weiterer Sender oder Störsender auftritt, der den Empfang und/oder die Peilung des nach dem Frequenzsprungverfahren arbeitenden Senders zusätzlich erschwert.

Der Empfang und/oder die Peilung eines nach dem Frequenzsprungverfahren arbeitenden Senders liesse sich dadurch ermöglichen, dass das eine bestimmte augenblickliche Frequenz aufweisende Signal dieses Senders im Empfänger mit einem Kammfrequenzspektrum gemischt wird. Die der Differenz aus der augenblicklichen Empfangsfrequenz und der benachbarten Komponente des Kammfrequenzspektrums entsprechende Zwischenfrequenz des gemischten Signales ist dann zeitlich konstant und kann zum Empfang und/oder zur Peilung des Senders herangezogen werden. Um eine Störung des Empfanges durch im Gesamtfrequenzbereich arbeitende Festsender zu verhindern, sollten die den Frequenzen dieser Festsender benachbarten Komponenten des Kammfrequenzspektrums unterdrückt werden können, so dass kein zwischenfrequentes Signal durch die Mischung dieser Komponenten mit der Frequenz der Festsender erzeugt wird.

Kammspektrumgeneratoren finden beispielsweise auch in Störsendern Verwendung, wie in der DE-A 3 322 325 vorgeschlagen. Der Kammspektrumgenerator gemäss der DE-A 3 322 325 soll Impulsgeneratorvorrichtungen zur Erzeugung einer Folge von Impulsen bei einer dem Kanalabstand der zu störenden Signale entsprechenden Frequenz aufweisen. Ein derartiger Kammspektrumgenerator sollte deshalb ebenfalls ein enges Frequenzraster aufweisen, um eine wirksame Überlagerung zu ermöglichen, wenn die Sprungfrequenzen des Senders ebenfalls ein enges Raster aufweisen.

Mit dem Kammspektrumgenerator gemäss DE-A 3 322 325 lässt sich ein breites Frequenzspektrum mit einer grossen Anzahl von Einzelfrequenzen in einem festen, lückenlosen Abstand zueinander erzeugen. Dieses Kammspektrum wird durch eine Impulsfolge erzeugt, wobei die Folgefrequenz den Rasterabstand, beispielsweise 25 kHz und die Impulsbreite die Breite des Spektrums bestimmt. Bei dem Kammspektrumgenerator gemäss DE-A 3 322 325 ist es nicht möglich, einzelne Frequenzen des Spektrums zu unterdrücken.

In US-A 3 644 827 wird ein Frequenzsyntheseverfahren beschrieben, bei dem Harmonische bestimmter untereinander synchronisierter Frequenzen, gemischt werden, wobei jeweils eine Harmonische aus jeder Gruppe von Harmonischen auf die Mischer geschaltet wird, um am Ausgang eine Frequenz innerhalb des realisierbaren Frequenzbereiches zu erhalten. Beim Verfahren gemäss US-A 3 644 827 wird aus einer einzigen Frequenzquelle eine gewünschte Frequenz in einem bestimmten Frequenzbereich erzeugt, wobei die Frequenzauflösung vorgebbar ist.

Im «Microwave Journal», Feb. 1982, S. 71–73 und S. 76–80 werden Synthesizer vorgestellt, die in im Frequenzsprungverfahren arbeitenden Systemen Anwendung finden. Diese können jedoch ihre Aufgabe in Sende- und Empfangsanlagen nur dann erfüllen, wenn sie eine entsprechende Synchronisationseinrichtung aufweisen. Auch diese Synthesizer liefern immer nur eine Frequenz und können nicht mehrere Frequenzen gleichzeitig liefern.

In der DE-A 1 591 481 wird ein Frequenzsynthetisator beschrieben, mit dem ein breiter Frequenzbereich schnell in diskreten Frequenzschritten mittels eines elektronischen Schalters überstrichen werden soll, ohne dass nennenswerte Schaltverzerrungen am Ausgang entstehen, und der die Ausgangsfrequenz rasch und mit hoher Genauigkeit liefern soll. Bei dem Frequenzsynthetisator gemäss der DE-A 1 591 481 stehen einerseits die diskrete Ausgangsfrequenz eines Frequenzgenerators und andererseits die zehn Ausgänge eines Spektrumgenerators zur Verfügung. Die entsprechenden Einzelfrequenzen sind über Schaltmittel und Mischer mischbar.

Der Erfindung liegt die Aufgabe zugrunde, einen Kammspektrum-Oszillator oder Kammfrequenzgenerator bereitzustellen, mit dem ein enges Frequenzraster über einen weiten Gesamtfrequenzbereich einfach zu erzeugen ist und der insbesondere dazu geeignet ist, einzelne Frequenzen des Rasters wahlweise und beliebig ab- und zuzuschalten.

Diese Aufgabe wird durch die Merkmale der Patentansprüche gelöst. Die Erfindung geht dabei von dem Grundgedanken aus, mindestens zwei synchronisierbare Rasterfrequenzgruppen derart zusammenzuschalten, dass beliebige Einzelfrequenzen innerhalb des gesamten Frequenzrasterbereiches gleichzeitig erzeugt werden können. Die Rasterfrequenzgruppen werden durch mindestens zwei Frequenzgruppengeneratoren erzeugt, und die Differenz der Einzelfrequenzen eines Rasters beträgt ein Vielfaches der Differenz der Einzelfrequenzen eines anderen Rasters. Auf diese Weise kann, wenn jede Einzelfrequenz des engeren Rasters mit jeder Einzelfrequenz des breiteren Rasters gemischt und die Summenfrequenz erzeugt wird, ein Kammfrequenzspektrum erzeugt werden, dessen Frequenzraster ebenso eng ist wie dasjenige des engeren Rasters und dessen Gesamtfrequenzbereich etwa der Summe der Gesamtfrequenzbereiche des engeren und des breiteren Rasters entspricht. Im Rahmen der Erfindung kann das vorstehende Mischprinzip auch mit mehr als zwei, beispielsweise drei oder mehr Rasterfrequenzgruppen realisiert werden, wobei jeweils die Differenz der Einzelfrequenzen des $(n+1)$ten Rasters einem Vielfachen der Differenz der Einzelfrequenzen des n-ten Rasters entspricht, mit $n = 1, 2, 3$ usw.. Auf diese Weise kann über einen sehr breiten Gesamtfrequenzbereich ein Kammspektrum erzeugt werden, dessen Frequenzraster jeweils dem Frequenzraster der engsten Rasterfrequenzgruppe entspricht. Vorzugsweise beträgt die Differenz der Einzelfrequenzen des $(n+1)$ten Rasters etwa das 10fache der Differenz der Einzelfrequenzen des n-ten Rasters, da sich auf diese Weise eine besonders günstige Überlagerungscharakteristik ergibt.

In einer bevorzugten Ausführungsform wird das Kammfrequenzspektrum im erfindungsgemässen Oszillator durch Frequenzsynthese aus zwei Rasterfrequenzgruppen erzeugt. Zur Frequenzsynthese ist eine Mischvorrichtung vorgesehen, in der beliebige Einzelfrequenzen des engeren Rasters wahlweise mit beliebigen Einzelfrequenzen des breiteren Rasters gleichzeitig kombiniert werden können; aus dem in dieser Vorrichtung durch Mischung der Frequenzen der beiden Rasterfrequenzgruppen erzeugten Frequenzspektrum wird jeweils die Summenfrequenz aus jeder Einzelfrequenz des engeren Rasters und jeder Einzelfrequenz des breiteren Rasters herausgefiltert. Vorzugsweise werden dabei die Einzelfrequenzen mindestens einer der beiden Rasterfrequenzgruppen, vorzugsweise des engeren Rasters, unabhängig voneinander und/oder gleichzeitig wahlweise den Eingängen der Frequenzsyntheseschaltung zugeführt. Die Frequenzsyntheseschaltung weist in diesem Fall eine bestimmte Anzahl einzelner Mischer auf, die der Anzahl der Einzelfrequenzen des breiteren Rasters entspricht. Auf diese Weise ist gewährleistet, dass am Ausgang der Frequenzsyntheseschaltung jede einzelne Summenfrequenz aus den Einzelfrequenzen der beiden Raster wahlweise und gleichzeitig abgegeben werden kann.

Für die wahlweise Zufuhr der Einzelfrequenzen an die Eingänge der Frequenzsyntheseschaltung ist vorzugsweise eine Schaltvorrichtung vorgesehen, mit der jede Einzelfrequenz wahlweise unterdrückt oder durchgelassen werden kann. Zu diesem Zweck weist die Schaltvorrichtung mehrere einzelne Schalter auf, durch die jeweils wahlweise eine einzelne Mischfrequenz aus je einer der Einzelfrequenzen der beiden Raster zuschaltbar ist. Dadurch lässt sich auf besonders einfache und übersichtliche Weise ein Kammfrequenzspektrum erzeugen, bei dem jede einzelne Frequenz oder jeder einzelne «Zacken» einzeln beeinflussbar ist und wahlweise zu- oder abgeschaltet werden kann. Ein derartiges Kammfrequenzspektrum ist besonders geeignet zur Verwendung in dem eingangs erläuterten Verfahren zum Empfang und/oder zur Peilung von nach dem Frequenzsprungverfahren arbeitenden Sendern, wobei im Gesamtfrequenzbereich dieses Senders ein oder mehrere Festsender mit fester Frequenz arbeiten. Die diesen festen Frequenzen benachbarten Frequenzen des Kammfrequenzspektrums lassen sich dann durch einfache Betätigung des die Erzeugung dieser Frequenz steuernden einzelnen Schalters unterdrücken, so dass kein die Peilung des nach dem Frequenzsprungverfahren arbeitenden Senders störendes zwischenfrequentes Signal durch Mischung dieser Frequenz mit der festen Frequenz des «Störsenders» erzeugt wird.

Am Ausgang der Mischvorrichtung ist vorzugsweise eine erste Filtervorrichtung mit mehreren Bandpassfiltern vorgesehen, wobei in den Durchlassbereich jedes einzelnen Bandpassfilters vorzugsweise jeweils eine Gruppe von durch Mischung von Einzelfrequenzen des engeren und des breiteren Rasters erzeugten Summenfrequenzen fällt. Vorzugsweise ist jeweils ein Bandpassfilter jeweils einem der Mischer der Mischvorrichtung zugeordnet, in dem eine Einzelfrequenz des breiteren Rasters mit allen, wahlweise zugeführten Einzelfrequenzen des engeren Rasters gemischt wird. Bei dieser Zuordnung umfasst die Durchlassbreite dieses Bandfilters alle Summenfrequenzen, die durch Mischung dieser Frequenz des breiteren Rasters mit allen Frequenzen des engeren Rasters erzeugt werden, und die Durchlassbreite jedes Bandpassfilters ist derart ausgelegt, dass sie den Gesamtfrequenzbereich des engeren Rasters umfasst. Die Durchlassbänder der einzelnen Bandpassfilter sind derart gestaffelt, dass sie unmittelbar aneinander anschliessen und die Durchlassbänder aller Filter zusammengenommen die kleinste und die grösste Summenfrequenz aus den verschiedenen Einzelfrequenzen des engeren und des breiteren Rasters umfassen.

Die Ausgänge der einzelnen Bandpassfilter der Filtervorrichtung werden einem Summationsverstärker zugeführt, der die Signale für die weitere Verarbeitung verstärkt.

Das verstärkte Kammfrequenzspektrum am Ausgang der Frequenzsyntheseschaltung liegt nicht unbedingt in derjenigen Frequenzlage, die für den jeweils eingesetzten Empfänger erforderlich ist. Das Kammfrequenzspektrum wird deshalb vorzugsweise durch Mischung mit einer wählbaren Basisfrequenz in einen geeigneten Frequenzbereich umgesetzt. Besonders einfach und variable lässt sich die wählbare Frequenz mittels eines Synthesizers erzeugen, an dessen Ausgang ein Signal mit einer frei wählbaren und abstimmbaren Frequenz anliegt. Das Kammfrequenzspektrum wird mit diesem Signal gemischt und dadurch in eine Frequenzlage umgesetzt, die der Summenfrequenz aus der Frequenz des Ausgangssignals des Synthesizers und den Einzelfrequenzen des Kammfrequenzspektrums entspricht. Dieser Frequenzbereich wird vorzugsweise mittels einer geeigneten zweiten Filtervorrichtung aus dem Frequenzspektrum am Ausgang des Mischers, in dem das Kammfrequenzspektrum und das Synthesizersignal gemischt werden, herausgefiltert. Zu diesem Zweck weist die zweite Filtervorrichtung vorzugsweise mehrere Bandpassfilter auf, deren Durchlassbreite ebenfalls jeweils etwas dem Gesamtfrequenzbereich des engeren Rasters entspricht. Auf diese Weise ist praktisch jeweils ein Bandpassfilter der zweiten Filtervorrichtung jeweils einem Bandpassfilter der ersten Vorrichtung und dadurch in einer bevorzugten Ausführungsform jeweils einem Mischer der Mischvorrichtung zugeordnet; der Durchlassbereich eines Filters der zweiten Filtervorrichtung ist ebenso breit wie der Durchlassbereich des ihm zugeordneten Filters der ersten Filtervorrichtung und gegenüber diesem um die vom Synthesizer gelieferte Basisfrequenz zu höheren Frequenzen verschoben. Auf diese Weise ergibt sich eine besondere genaue Filterung der einzelnen Signale und dadurch ein besonders genaues und stabiles Kammfrequenzspektrum.

Wenn alle Einzelfrequenzen der beiden überlagerten Rasterfrequenzgruppen zugeschaltet sind, werden in der vorstehend erläuterten bevorzugten Ausführungsform jedem Mischer der Frequenzsyntheseschaltung und jedem Bandpassfilter der ersten und der zweiten Filtervorrichtung jeweils eine Anzahl von Signalen zugeführt, die der Zahl der Einzelfrequenzen des engeren Rasters entspricht. Wenn dem zugeordneten Mischer der Mischvorrichtung weniger Einzelfrequenzen des engeren Rasters zugeführt werden, verringert sich entsprechend auch die Anzahl der Frequenzen, die in das Durchlassband des zugehörigen Filters der ersten und der zweiten Filtervorrichtung fallen. Der Aufbau der Vorrichtung lässt sich dadurch besonders ökonomisch ausgestalten, dass jeweils nur diejenigen Bandpassfilter der ersten und der zweiten Filtervorrichtung eingeschaltet werden, deren zugeordnetem Mischer mindestens eine der Einzelfrequenzen des engeren Rasters zugeführt werden. Sind alle Schalter, die einem bestimmten Mischer wahlweise die Einzelfrequenzen des engeren Rasters zuführen, ausgeschaltet, sind auch die zugehörigen Bandpassfilter der ersten und der zweiten Filtervorrichtung ausser Funktion.

In einer besonders einfachen Ausführungsform können auch sämtliche Bandpassfilter der zweiten Filtervorrichtung eine Durchlassbreite aufweisen, die dem Gesamtfrequenzbereich der ersten Filteranordnung entspricht. Die Anzahl und Umschaltung dieser Bandpassfilter ist dann abhängig vom gewünschten Empfangsbereich des verwendeten Empfängers und/oder Peilers und damit auch von der Variation der Basisfrequenz des Synthesizers.

Das in die gewünschte Frequenzlage umgesetzte Kammfrequenzspektrum wird verstärkt, und das nunmehr in den gewünschten Empfängerfrequenzbereich umgesetzte Kammfrequenzspektrum liegt am Ausgang des Verstärkers an. Wenn das Kammfrequenzspektrum des erfindungsgemässen Kammspektrum-Oszillators in einer Vorrichtung zum Empfang von Signalen und/oder zur Peilung von nach dem Frequenzsprungverfahren arbeitenden Sendern verwendet wird, wird dieses Kammfrequenzspektrum dem Mischer einer derartigen Peilvorrichtung zugeführt und dort mit dem augenblicklich empfangenen Signal des zu peilenden Senders gemischt. Das als Mischprodukt erzeugte zwischenfrequente Signal wird dann zur Peilung des Senders herangezogen.

Der erfindungsgemässe Kammspektrum-Oszillator weist vorzugsweise eine zentrale Steuervorrichtung auf. Diese Steuervorrichtung synchronisiert die meistens zwei Rasterfrequenzgruppen, aus denen das Kammfrequenzspektrum gemischt wird, die Schaltvorrichtung, mittels der einzelne Frequenzen des Kammfrequenzspektrums zu- und abschaltbar sind, die vom Synthesizer gelieferte wählbare Frequenz und die zweite Filgervorrichtung. Die Steuervorrichtung ist vorzugsweise derart ausgestaltet, dass sich mit ihr alle Einzelfrequenzen des gewünschten Kammfrequenzspektrums vorgeben und einstellen lassen.

Mit dem erfindungsgemässen Kammspektrum-Oszillator lässt sich somit jedes beliebige, gewünschte Kammfrequenzspektrum auf einfache Weise einstellen und vorgeben. Vorzugsweise sind die Einzelfrequenzen aller Rasterfrequenzgruppen, aus denen das Kammfrequenzspektrum synthetisiert wird, nach einer arithmetischen Reihe gestaffelt, wobei die Differenz zwischen benachbarten Frequenzen jeder Rasterfrequenzgruppe jeweils gleich gross ist. Die Frequenzen insbesondere der engeren Rasterfrequenzgruppe können jedoch auch beliebig gestaffelt sein; wenn ein derartiges beliebiges Raster mit einem als arithmetische Reihe gestaffelten breiteren Raster gemischt wird, wiederholt sich das beliebige engere Raster periodisch im Gesamtfrequenzbereich.

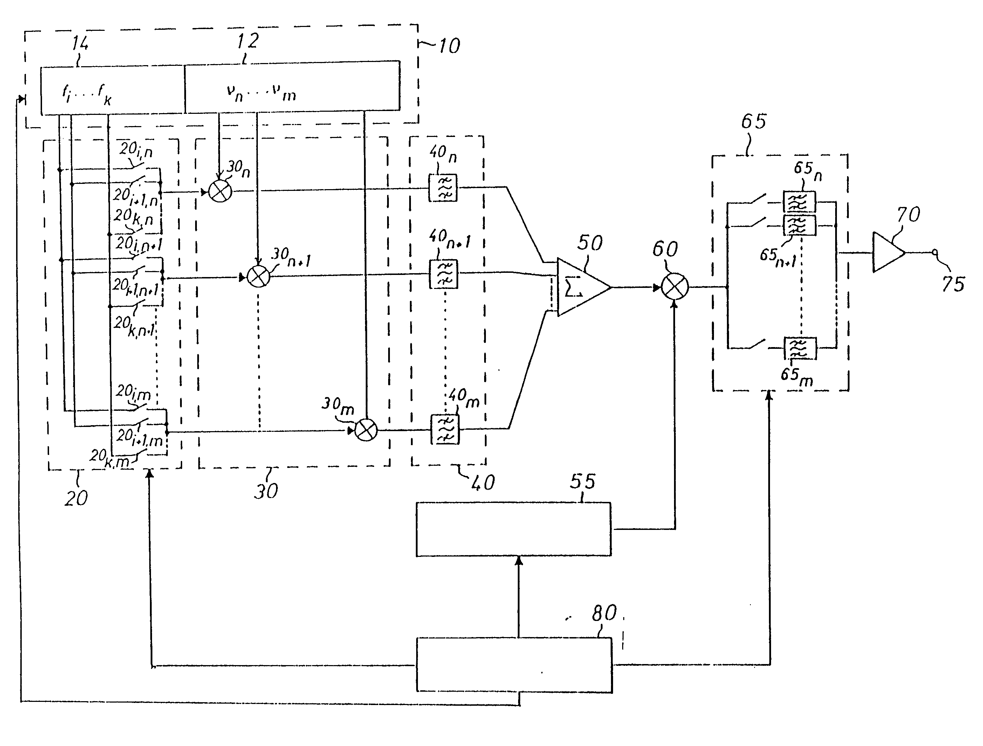

Die Erfindung wird nachstehend anhand der Zeichnung näher erläutert. Die Figur zeigt schematisch eine Ausführungsform des erfindungsgemässen Kammspektrum-Oszillators.

Es sei angenommen, dass der gesamte Empfangsbereich von 30 bis 92,475 MHz in zehn Bereiche mit je 6,25 MHz Breite unterteilt ist; diese Bereiche sollen jeweils ein 25 kHz-Frequenzraster aufweisen. Dieses Frequenzraster ist frei und beliebig wählbar. Bei der Wahl eines 25 kHz-Rasters umfasst jeder der zehn Bereiche 250 Kanäle.

Das Kammfrequenzspektrum in jedem Bereich soll durch Frequenzsynthese aus zwei synchronisierbaren Rasterfrequenzgruppen erzeugt werden. Das Raster der engeren Rasterfrequenzgruppe beträgt dann ebenfalls 25 kHz. Vorzugsweise umfasst die engere Rasterfrequenzgruppe 10 Frequenzen $f_i$ bis $f_k$ im Bereich von 5,15 bis 5,375 MHz in einem Raster von 25 kHz. Die breitere Rasterfrequenzgruppe umfasst vorzugsweise 25 Frequenzen $v_n$ bis $v_m$ im Bereich von 1,25 bis 7,25 MHz in einem Raster von 250 kHz. Durch Synthese dieser beiden Rasterfrequenzengruppen lassen sich insgesamt 250 Linien oder Sammelfrequenzen in einem Frequenzbereich von 6,4 bis 12,625 MHz mit einem Raster von 25 kHz erzeugen.

Der erfindungsgemässe Kammspektrum-Oszillator gemäss der Figur weist einen Frequenzgenerator 10 mit einem ersten Frequenzgruppengenerator 12 und einem zweiten Frequenzgruppengenerator 14 auf. Der erste Frequenzgruppengenerator 12 erzeugt 25 Einzelfrequenzen $v_n \ldots v_m$ im Bereich von 1,25 bis 7,25 MHz mit einem 250 kHz-Raster. Der zweite Frequenzgenerator 14 erzeugt 10 Einzelfrequenzen $f_i \ldots f_k$ im Bereich von 5,15 bis 5,375 MHz mit einem 25 kHz-Raster. Die vom zweiten Frequenzgruppengenerator 14 erzeugten Einzelfrequenzen $f_i \ldots f_k$ werden durch eine Schaltvorrichtung 20 wahlweise den Eingängen einer Mischvorrichtung 30 zugeführt, in der sie mit den Einzelfrequenzen $v_n \ldots v_m$ des ersten Frequenzgruppengenerators 12 gemischt werden. Jede Einzelfrequenz $f_i, f_{i+1} \ldots f_k$ wird wahlweise mit jeder Einzelfrequenz $v_n, v_{n+1} \ldots v_m$ gemischt. Um jede als Mischprodukt erzeugte Summenfrequenz beliebig zu- und abschalten zu können, weist die Schaltvorrichtung 20 mehrere einzelne Schalter $20_{i, n} \ldots 20_{k, m}$ auf, deren Anzahl dem Produkt aus der Zahl der Einzelfrequenzen der ersten und der zweiten Rasterfrequenzgruppe entspricht. Beispielsweise wird durch Schliessen des Schalters $20_{i+1, n+1}$ die Einzelfrequenz $f_{i+1}$ der zweiten Rasterfrequenzgruppe dem Mischer $30_{n+1}$ der Mischvorrichtung 30 zugeführt, wo die Einzelfrequenz $f_{i+1}$ mit der Einzelfrequenz $v_{n+1}$ der ersten Rasterfrequenzgruppe gemischt wird. In ähnlicher Weise lässt sich jeweils durch Schliessen oder Öffnen der einzelnen Schalter $20_{i, n} \ldots 20_{k, m}$ beliebig wählen, so jede Summenfrequenz $f_1 v_n$ bis $f_k v_m$ dem Kammfrequenzspektrum zugeschaltet oder unterdrückt werden soll.

Die Mischvorrichtung 30 weist mehrere Mischer $30_n, 30_{n+1} \ldots 30_m$ auf, deren Zahl der Zahl der Einzelfrequenzen des ersten, breiteren Frequenzrasters entspricht und die jeweils einer dieser Einzelfrequenzen zugeordnet sind. Im Mischer $30_n$ wird die Einzelfrequenz $v_n$ des ersten Frequenzrasters mit denjenigen Frequenzen $f_i, f_{i+1} \ldots f_k$ des zweiten Frequenzrasters gemischt, deren zugeordnete Schalter $20_{i, n}, 20_{i+1, n} \ldots 20_{k, n}$ geschlossen sind. Das gleiche gilt für die weiteren Mischer $30_{n+1}$ bis $30_m$.

Die Ausgangssignale der einzelnen Mischer $30_n \ldots 30_m$ werden den zugeordneten Bandpassfiltern $40_n \ldots 40_m$ der ersten Filtervorrichtung 40 zugeführt. Die Bandpassfilter $40_n$ bis $40_m$ weisen jeweils eine dem gesamten Frequenzbereich der zweiten Rasterfrequenzgruppe entsprechende Durchlassbandbreite von 225 kHz auf und unterteilen den Frequenzbereich von 6,4 MHz bis 12,625 MHz in 25 Bereiche. Beispielsweise weist das erste Bandpassfilter $40_n$ eine Bandbreite von 6,4 bis 6,625 MHz auf. Die Ausgangssignale der Bandpassfilter $40_n \ldots 40_m$ der ersten Filtervorrichtung 40 werden einem Summationsverstärker 50 zugeführt. Am Ausgang des Summationsverstärkers 50 liegt ein Kammfrequenzspektrum von 6,4 bis 12,625 MHz mit einem Raster von 25 kHz, wobei die Zuschaltung der einzelnen Frequenzen oder «Zacken» des Kamms über die Schalter $20_{i, n} \ldots 20_{k, m}$ frei wählbar ist.

Dieses Kammfrequenzspektrum kann in den gewünschten Frequenzbereich des Empfängers transferiert werden. Zu diesem Zweck ist ein Synthesizer 55 vorgesehen, dessen Ausgangsfrequenz $L_O$ frei wählbar und abstimmbar ist und in einem Mischer 60 mit dem am Ausgang des Summenverstärkers 50 anliegenden Kammfrequenzspektrum gemischt wird. Wenn beispielsweise am Ausgang des Kammspektrum-Oszillators ein Frequenzbereich $L_O' = 430 \ldots 436, 225$ MHz gewünscht wird, muss $L_O$ auf 423,6 MHz eingestellt werden. Die durch Mischung mit dem Kammfrequenzspektrum im Mischer 60 erzeugten Summenfrequenzen liegen dann im Bereich von 430 bis 436,225 MHz.

Aus dem im Mischer 60 erzeugten Frequenzspektrum werden in einer zweiten Filtervorrichtung 65 die gewünschten Summenfrequenzen herausgefiltert. Die zweite Filtervorrichtung 65 weist vorzugsweise mehrere Bandpassfilter $65_n, 65_{n+1} \ldots 65_m$ auf, die jeweils einem der Bandpassfilter $40_n, 40_{n+1} \ldots 40_m$ der ersten Filtervorrichtung 40 zugeordnet werden können und ebenfalls eine Durchlassbreite von 225 kHz aufweisen. Das Durchlassband der Bandpassfilter $65_n \ldots 65_m$ der zweiten Filtervorrichtung ist gegenüber dem Durchlassband jedes zugeordneten Filters $40_n \ldots 40_m$ der ersten Filtervorrichtung um die Ausgangsfrequenz $L_O$ des Synthesizers 55 zu höheren Frequenzen verschoben. Beispielsweise weist das erste Bandpassfilter $65_n$ eine Bandbreite von 430 bis 430,225 MHz, das zweite Bandpassfilter $65_{n+1}$ eine Durchlassbreite von 430,250 bis 430,475 MHz und das Bandpassfilter $65_m$ eine Durchlassbreite von 436 bis 436,225 MHz auf. Die zweite Filtervorrichtung 65 kann auch in einer einfachen Ausführungsform eine Durchlassbreite aufweisen, die dem Gesamtfrequenzbereich der ersten Filteranordnung entspricht.

Das Ausgangsignal der zweiten Filtervorrichtung 65 wird in einem Verstärker 70 verstärkt und liegt als Signal $L_O'$ am Ausgang 75 des Kammspektrum-Oszillators an. Dieses Ausgangssignal $L_O'$ mit einer Frequenz von 430 bis 436,225 MHz kann dann beispielsweise als Mischoszillatorsignal eines Empfängers mit einer Zwischenfrequenz von 400 MHz für den gewünschten Teilempfangsbereich von 30 bis 36,225 MHz verwendet werden.

Vorzugsweise wird die Frequenzsynthese und die Wahl der zugeschalteten Einzelfrequenzen des Kammfrequenzspektrums mittels einer Steuervorrichtung 80 synchronisiert. Die Steuervorrichtung 80 ist mit dem Frequenzgenerator 10, der Schaltvorrichtung 20, dem Synthesizer 55 und der zweiten Filtervorrichtung 65 verbunden. Mit der Steuervorrichtung 80 können sowohl die beiden Rasterfrequenzgruppen des ersten und zweiten Frequenzgenerators 12, 14 synchronisiert als auch die Zuschaltung der einzelnen «Zacken» des Kammfrequenzspektrums mittels der Schalter der Schaltvorrichtung 20 eingestellt und des Kammfrequenzspektrum in einen frei wählbaren Frequenzbereich umgesetzt und gefiltert werden. Durch die zentrale Steuervorrichtung 80 ist also eine besonders einfache, rasche und sichere Auswahl eines beliebigen Kammfrequenzspektrums am Ausgang des erfindungsgemässen Kammspektrum-Oszillators möglich.

## Patentansprüche

1. Kammspektrum-Oszillator zum Erzeugen eines Kammfrequenzspektrums durch Frequenzsynthese aus mindestens zwei durch Frequenzgruppengeneratoren (12, 14) erzeugten, synchronisierbaren Rasterfrequenzgruppen mit unterschiedlicher Differenz der Einzelfrequenzen, wobei die Differenz der Einzelfrequenzen $(v_n \ldots v_m)$ eines breiteren Rasters etwa ein Vielfaches der Differenz der Einzelfrequenzen $(f_i \ldots f_k)$ eines engeren Rasters beträgt und jeder Einzelfrequenz $(v_n \ldots v_m)$ des breiteren Rasters ein Mischer $(30_n \ldots 30_m)$ zugeordnet ist, über den diese Einzelfrequenz $(v_n \ldots v_m)$ beliebig mit den Einzelfrequenzen des engeren Rasters mischbar ist, und die Ausgänge der Mischer $(30_n \ldots 30_m)$ über einen Summationsverstärker (50) zusammengefasst werden, um das Kammfrequenzspektrum zu erzeugen.

2. Vorrichtung nach Anspruch 1, dadurch gekennzeichnet, dass die Mischer $(30_n \ldots 30_n)$ eine Mischvorrichtung (30) bilden, in der beliebige Einzelfrequenzen $(f_i \ldots f_k)$ des engeren Rasters mit beliebigen Einzelfrequenzen $(v_n \ldots v_m)$ des breiteren Rasters gleichzeitig kombiniert werden können, so dass innerhalb des Gesamtfrequenzbereiches ein Kammfrequenzspektrum erzeugbar ist, dessen Rasterung der Rasterung des engeren Rasters entspricht.

3. Vorrichtung nach Anspruch 1 oder 2, gekennzeichnet durch eine Schaltvorrichtung (20), mit der die einzelnen Frequenzen des Kammfrequenzspektrums beliebig ein- und ausschaltbar sind.

4. Vorrichtung nach Anspruch 3, dadurch gekennzeichnet, dass die Schaltvorrichtung (20) mehrere einzelne Schalter $(20_{i, n} \ldots 20_{k, m})$ aufweist, durch die jeweils die Kombination einer der Einzelfrequenzen $(f_i \ldots f_k)$ des engeren Rasters mit einer der Einzelfrequenzen $(v_n \ldots v_m)$ des breiteren Rasters steuerbar ist.

5. Vorrichtung nach einem der Ansprüche 2 bis 4, gekennzeichnet durch eine erste Filtervorrichtung (40) mit mehreren Bandpassfiltern $(40_n \ldots 40_m)$ am Ausgang der Mischvorrichtung (30).

6. Vorrichtung nach Anspruch 5, dadurch gekennzeichnet, dass der Summationsverstärker (50) die Ausgangssignale der ersten Filtervorrichtung (40) vestärkt.

7. Vorrichtung nach einem der Ansprüche 1 bis 6, gekennzeichnet, durch eine Synthesizer (55) zum Erzeugen einer wählbaren Frequenz, die in einem Mischer (60) mit dem Kammfrequenzspektrum gemischt wird.

8. Vorrichtung nach Anspruch 7, gekennzeichnet, durch eine zweite Filtervorrichtung (65) zum Filtern des umgesetzten Kammfrequenzspektrums.

9. Vorrichtung nach Anspruch 8, gekennzeichnet durch eine zentrale Steuervorrichtung (80), die die Frequenzraster der mindestens zwei Frequenzgruppengeneratoren (12, 14), die Schaltvorrichtung (20), die wählbare Frequenz des Synthesizers (55) und die Filterung des umgesetzten Kammfrequenzspektrums synchronisiert.

## Claims

1. Comb spectrum oscillator for producing a comb frequency spectrum by frequency synthesis from at least two synchronisable raster frequency groups which are produced by frequency group generators (12, 14) and have a varying difference of the individual frequencies, the difference of the individual frequencies $(v_n \ldots v_m)$ of a broader raster approximately a multiple of the difference of the individual frequencies $(f_i \ldots f_k)$ of a narrower raster and associated with each individual frequency $(v_n \ldots v_m)$ of the broader raster is a mixer $(30_n \ldots 30_m)$ by means of which this individual frequency $(v_n \ldots v_m)$ may be mixed at will with the individual frequencies of the narrow raster and the outputs of the mixers $(30_n \ldots 30_m)$ are combined by means of a summation amplifier (50) in order to produce the comb frequency spectrum.

2. Apparatus as claimed in claim 1, characterised in that the mixers $(30_n \ldots 30_m)$ form a mixing device (30) in which any desired individual frequencies $(f_i \ldots f_k)$ of the narrower raster be simultaneously combined with any desired individual

frequencies $(v_n \ldots v_m)$ of the broader raster so that within the entire frequency range a comb frequency spectrum may be produced whose resolution corresponds to the resolution of the narrower raster.

3. Apparatus as claimed in claim 1 or 2, characterised by a switching device (20) with which the individual frequencies of the comb frequency spectrum may be switched on and off at will.

4. Apparatus as claimed in claim 3, characterised in that the switching device (20) has individual switches $(20_{i,\,n} \ldots 20_{k,\,m})$ by which in each case the combination of one raster with one of the individual frequencies $(v_n \ldots v_m)$ of the broader raster may be controlled.

5. Apparatus as claimed in one of claims 2 to 4, characterised by a first filter device (40) with a plurality of band pass filters $(40_n \ldots 40_m)$ at the output of the mixing device (30).

6. Apparatus as claimed in claim 5, characterised in that the summation amplifier (50) amplifies the output signals of the first filter device (40).

7. Apparatus as claimed in one of claims 1 to 6, characterised by a synthesizer (55) for producing a selectable frequency which is mixed in a mixer (60) with the comb frequency spectrum.

8. Apparatus as claimed in claim 7, characterised by a second filter device (65) for filtering the converted comb frequency spectrum.

9. Apparatus as claimed in claim 8, characterised by a central control device (80) which synchronises the frequency raster of the at least two frequency group generators (12, 14), the switching device (20), the selectable frequency of the synthesizer (55) and the filtering of the converted comb frequency spectrum.

**Revendications**

1. Oscillateur à spectre en peigne destiné à la production d'un spectre de fréquences en peigne par synthèse des fréquences provenant d'au moins deux groupes de fréquences de trame synchronisables produits par des générateurs de groupes de fréquences (12, 14) avec des différences distinctes entre les fréquences individuelles, caractérisé en ce que la différence entre les fréquences individuelles $(v_n \ldots v_m)$ d'une trame plus large représente sensiblement un multiple de la différence entre les fréquences individuelles $(f_i \ldots f_k)$ d'une trame plus étroite et en ce qu'à chaque fréquence individuelle $(v_n \ldots v_m)$ de la trame plus large est affecté un mélangeur $(30_n \ldots 30_m)$ au moyen duquel cette fréquence individuelle $(v_n \ldots v_m)$ peut être mélangée à volonté avec les fréquences individuelles de la trame la plus étroite et en ce que les sorties des mélangeurs $(30_n \ldots 30_m)$ sont regroupées par l'intermédiaire d'un amplificateur sommateur (50) pour produire le spectre de fréquences en peigne.

2. Dispositif selon la revendication 1, caractérisé en ce que les mélangeurs $(30_n \ldots 30_m)$ forment (30) dans lequel des fréquences individuelles quelconques $(f_i \ldots f_k)$ de la trame la plus étroite peuvent être combinées simultanément à des fréquences individuelles quelconques $(v_n \ldots v_m)$ de la trame la plus large, de manière qu'à l'intérieur de la plage totale des fréquences puisse être produit un spectre de fréquences en peigne dont le tramage correspond au tramage de la trame la plus étroite.

3. Dispositif selon l'une des revedications 1 ou 2, caractérisé par un dispositif de commutation (20) au moyen duquel les fréquences individuelles du spectre de fréquences en peigne peuvent être admises ou arrêtées à volonté.

4. Dispositif selon la revendication 3, caractérisé en ce que le dispositif de commutation (20) comprend plusieurs commutateurs $(20_{i,\,n} \ldots 20_{k,\,m})$ au moyen desquels peut être respectivement réalisée la combinaison de l'une des fréquences individuelles $(f_i \ldots f_k)$ de la trame la plus étroite avec l'une des fréquences individuelles $(v_n \ldots v_m)$ de la trame la plus large.

5. Dispositif selon l'une des revendications 2 à 4, caractérisé par un premier dispositif à filtres (40) comprenant plusieurs filtres passe-bande $(40_n \ldots 40_m)$ à la sortie du dispositif mélangeur (30).

6. Dispositif selon la revendication 5, caractérisé en ce que l'amplificateur sommateur (50) amplifie les signaux de sortie du premier dispositif à filtres (40).

7. Dispositif selon l'une des revendications 1 à 6, caractérisé par un synthétiseur (55) pour produire une fréquence que l'on peut choisir, qui est mélangée dans un mélangeur (60) au spectre de fréquences en peigne.

8. Dispositif selon la revendication 7, caractérisé par un second dispositif à filtres (65) pour filtrer le spectre de fréquences en peigne modifié.

9. Dispositif selon la revendication 8, caractérisé par une unité de commande centrale (80) qui synchronise les trames des fréquences des deux générateurs de groupe de fréquences (12, 14) au moins, le dispositif de commutation (20), la fréquence du synthétiseur (55) que l'on peut choisir et le filtrage du spectre de fréquences en peigne modifié.